(19) Europäisches Patentamt
European Patent Office
Office européen des brevets

(11) **EP 3 264 114 A1**

(12) **EUROPEAN PATENT APPLICATION**
published in accordance with Art. 153(4) EPC

(43) Date of publication:
**03.01.2018 Bulletin 2018/01**

(51) Int Cl.:
*G01R 31/08* (2006.01)     *H02H 3/00* (2006.01)

(21) Application number: **16755141.5**

(22) Date of filing: **01.02.2016**

(86) International application number:
**PCT/JP2016/052847**

(87) International publication number:
**WO 2016/136391 (01.09.2016 Gazette 2016/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **27.02.2015 JP 2015037620**

(71) Applicant: **Hitachi, Ltd.**
**Tokyo 100-8280 (JP)**

(72) Inventors:
• **TSUNEDOMI Kunihiko**
**Tokyo 100-8280 (JP)**
• **WATANABE Masahiro**
**Tokyo 100-8280 (JP)**
• **FURUKAWA Kenta**
**Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(54) **FAULT POINT LOCATING DEVICE AND METHOD, ELECTRIC POWER SYSTEM MONITORING SYSTEM, AND FACILITY PLANNING SUPPORT SYSTEM**

(57) An electric power system monitoring system in which a conventional fault point locating scheme has been implemented obtains a fault point location as a single point, in the form of distances from sensors. However, there are errors in electric current sensors and voltage sensors which are used for such sensors, and there is thus a problem in that errors arise between the fault point obtained by the electric power system monitoring system and the actual fault point, in other words a locating error arises. Further, the impedance of the system varies depending on the system status. This variation is also a problem in that it results in a magnification of the locating error in a conventional fault point locating scheme. In order to resolve these problems, the present invention relates to a fault point locating device which estimates a fault point in an electric power system, characterized in being provided with: a variation range calculating means which obtains a range of variation of sensor values and a range of variation of an impedance of the electric power system, on the basis of the sensor values, which include measured voltage values and measured current values before and after the fault and which are measured using sensors installed in the electric power system, sensor errors representing error ranges of the sensors in relation to the sensor value measurements, said impedance, and an impedance variation parameter for determining the range of variation of the impedance; a combination cre-
ating means which creates combinations of values that the sensor values and the impedance value could attain, on the basis of the variation ranges obtained by the variation range calculating means; and a fault point locating means which calculates a fault point range representing distances from the sensors to the fault point, on the basis of the combinations.

[Fig. 1]

SENSOR VALUE (2)   SENSOR ERROR (3)   IMPEDANCE (4)   IMPEDANCE VARIATION PARAMETER (5)

FAULT POINT LOCATING DEVICE (1)

SENSOR VALUE RANGE CALCULATING MEANS (6)

IMPEDANCE RANGE CALCULATING MEANS (7)

COMBINATION CREATING MEANS (8)

FAULT POINT LOCATING MEANS (9)

DETERMINING MEANS (10)

FAULT POINT RANGE (11)   DETERMINATION NOT POSSIBLE FLAG (12)

**Description**

Technical Field

The present invention relates to a fault point locating device and method which estimate a fault point when system fault is generated in an electric power system. In addition, the invention relates to an electric power system monitoring system or a facility planning support system supporting installation planning of system facilities, which communicates with the fault point locating device.

Background Art

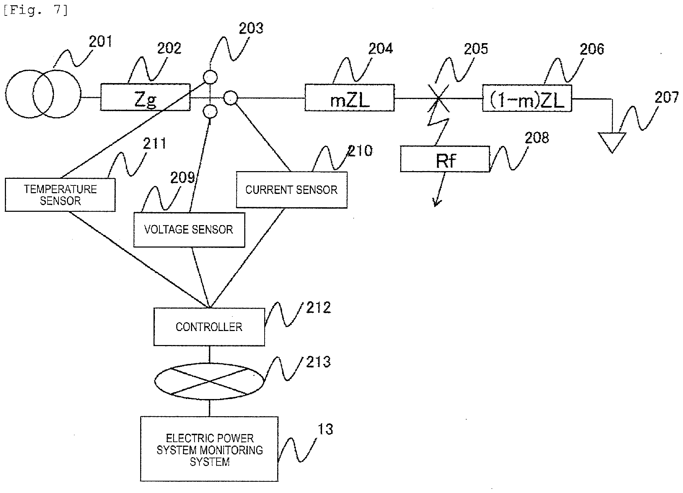

As a background art of this technical field, there is US Patent No. 4313169 (PTL 1). PTL 1 discloses that "in order to locate a malfunction point of an electric power system without being influenced by resistance of a fault point, a sensor, which is installed in an end of a system, measures current and a voltage of a line at the time of generating a fault, and calculates a distance between the sensor and the fault point from a measured value and an impedance of the system." (refer to abstract).
In addition, there is "C37. 114-2004 IEEE Guide for Determining Fault Location on AC Transmission and Distribution Lines" (NTL 1). In this document, a fault point locating scheme disclosed in PTL 1 is described.
A principle disclosed in NTL 1 will be described with rating of a fault point of a system illustrated in Fig. 7 as an example. An impedance from a distribution substation 201 of the system to a load 207 is set to ZL. An electric current sensor 210 and a voltage sensor 209 are installed in a busbar 203 of the distribution substation 201, and a current Ipre before generating the fault is measured. Also, current Ig and a voltage Vg at the time of generating a ground fault or a short fault of a resistance Rf in the fault point 205 are measured. At this time, a distance m from the busbar 203 to the fault point 205 can be obtained using (Equation 1) and (Equation 2).

[Equation 1]

$$m = \frac{Im(V_g \Delta I_g^*)}{Im(Z_L I_g \Delta I_g^*)}$$

[Equation 2]

$$\Delta I_g = I_g - I_{pre}$$

However, $\Delta I_g^*$ represents a conjugate complex number of $\Delta I_g$, Im represents an imaginary part of the equation. The voltage Vg, the current Ig, and Ipre which are used vary in accordance with types of the fault. In a case of a one-line ground fault, a phase voltage and phase current of a ground fault phase are used. In a case of a three-line ground fault, a three-line short fault, a two-line short fault, and a two-line ground fault, a line voltage and line current of a line where the fault is generated are used.

Citation List

Patent Literature

PTL 1: US Patent No. 4313169

NTL 1: C37. 114-2004 IEEE Guide for Determining Fault Location on AC Transmission and Distribution Lines

Summary of Invention

Technical Problem

An electric power system monitoring system in which a fault point locating scheme disclosed in PTL 1 is implemented obtains a fault point location as a single point, in the form of distances from sensors. However, there are errors in an electric current sensor 210 or a voltage sensor which are used for sensors, and thus there is a problem in that errors arise between the fault point obtained by the electric power system monitoring system and an actual fault point, that is, a locating error arises. In addition, an impedance of the system varies depending on a status of the system. For example, if a temperature of a transmission and distribution line increases, resistance per unit increases, and a span length of the system is also lengthened. This variation is also a problem in that it results in a magnification of the locating error in the fault point locating scheme in the related art.
In the electric power system monitoring system, if the locating error is great, a person who performs maintenance needs more time for searching a fault point, and thus a blackout time increases. In addition, if a range of the locating error is not found, the person who performs maintenance cannot be allocated to an optimal work, and thus costs of maintenance increase. In addition, if an expensive sensor with high accuracy is installed in order to reduce the locating errors, costs of a facility increase.

Solution to Problem

In order to solve the above-described problems, according to the invention, there is provided a fault point locating device which estimates a fault point in an electric power system, the device includes variation range calculating means for obtaining a range of variation of sensor values and an impedance, based on a sensor value including a measured voltage value and a measured current value before and after fault, which are measured using sensors installed in the electric power system, a sensor error representing an error range of the sensor in relation to measurement of the sensor value, an impedance of the electric power system, and an impedance variation parameter for determining the range of variation of the impedance, combination creating means for creating a combination of values that the sensor value and the impedance are able to attain, based on the range of variation obtained by the variation range calculating means, and fault point locating means for calculating a fault point range representing a distance from the sensor to the fault point based on the combination.

Advantageous Effects of Invention

According to the invention, it has an effect that, even when there is a sensor error or a variation of impedance, a range in which a malfunction point is present is found, and thus a person who performs maintenance accurately estimates time for searching a fault point. Therefore, in order to shorten a searching time and accomplish maintenance within a target blackout time, an optimal number of the persons who perform maintenance can be allocated, and thus costs of maintenance can be reduced. In addition, if the invention is applied to a system or the like which monitors an electric power system and supports a facility planning, the locating error is estimated from a selecting stage of a sensor, and therefore, a low cost sensor which has minimum errors is selected, and costs of a facility can be reduced.

Brief Description of Drawings

[Fig. 1] Fig. 1 illustrates a software configuration of a fault point locating device 1.
[Fig. 2] Fig. 2 illustrates a software configuration of an electric power system monitoring system.
[Fig. 3] Fig. 3 illustrates a software configuration of a facility planning support system.
[Fig. 4] Fig. 4 illustrates a hardware configuration of the fault point locating device 1.
[Fig. 5] Fig. 5 illustrates a hardware configuration of the electric power system monitoring system.
[Fig. 6] Fig. 6 illustrates the software configuration of the facility planning support system.
[Fig. 7] Fig. 7 illustrates an entire view of an electric power system.
[Fig. 8] Fig. 8 illustrates an impedance table. Description of Embodiments

Hereinafter, examples will be described with reference to drawings.

Example 1

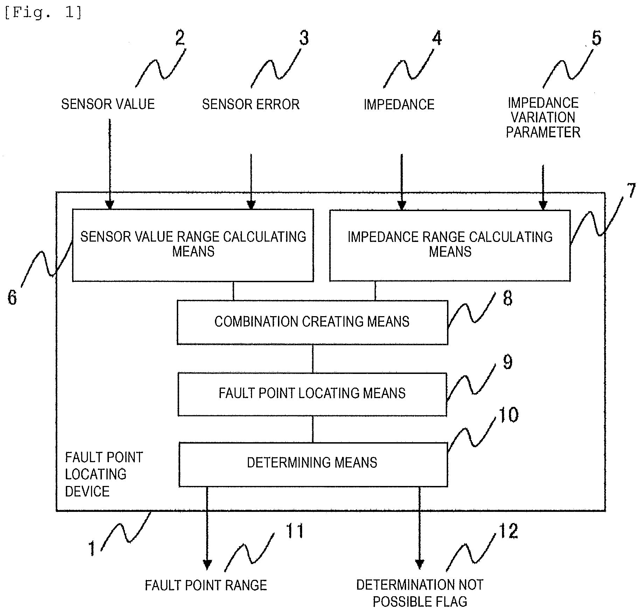

Fig. 1 is an example of a diagram of a software configuration of a fault point locating device 1 in this example. In Fig. 1, a sensor value 2, a sensor error 3, an impedance 4, and an impedance variation parameter 5 are input values of a fault point locating system 21. In addition, a fault point range 11 and a determination not possible flag 12 are output values of the fault point locating device 1. Sensor value range calculating means 6, impedance range calculating means 7, combination creating means 8, fault point locating means 9, and determining means 10 are processes of the invention. First, the input values and the output values will be described hereinafter.

As the sensor value 2, there are a voltage Vg at the time of the fault, current Ig at the time of the fault, and current Ipre before the fault, which are measured by a voltage sensor 209 in Fig. 7. These values are finely stored at a cycle of eight times or more of a system frequency by a controller 212, and are copied to the fault point locating system 21 through communication or a recording medium such as a USB memory. Also, in the controller 212, in order to store the current Ig at the time of the fault and the current Ipre before the fault, generation of fault needs to be detected. In this detection, it is detected whether or not current is deviated from a range of normal current which is set in advance..

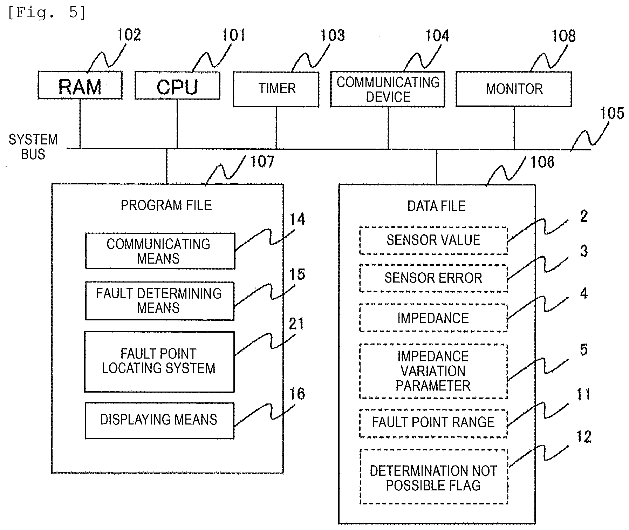

The sensor error 3 is a value obtained by normalizing a difference between a measurement value and a true value of the voltage sensor 209 and an electric current sensor 210 in Fig. 7, and is a value from zero to 1. The impedance 4 is an impedance 4 of an electric power system from a busbar 203 to a load 207 in Fig. 7. The impedance variation parameter 5 is a temperature or time. Any one of the parameters is used by the impedance range calculating means 7. In a case in which the parameter is a temperature, temperatures of the busbar 203, a transmission and distribution line, or peripherals thereof which are measured by a temperature sensor 211 in Fig. 7 are stored. In a case in which the parameter is time, a value of a timer 103 of the fault point locating device 1 illustrated in Fig. 5 is used.

Next, processes of the example will be described in order of processing.

First, the sensor value range calculating means 6 calculates a minimum current value Ipremin before the fault, a maximum current value Ipremax before the fault, a minimum current value Igmin after the fault, a maximum current value Igmax after the fault, a minimum voltage value Vgmin after the fault, and a maximum voltage value Vgmax after the fault, using (Equation 3) to (Equation 8). However, an error E1 of the electric current sensor 210 is set to ($0 \leq E1 \leq 1$), and an error E2 of the voltage sensor 209 is set to ($0 \leq E2 \leq 1$).

[Equation 3]

$$[I_{premin}=I_{pre}\times(1-E_1)$$

[Equation 4]

$$[I_{premax}=I_{pre}\times(1+E_1)$$

[Equation 5]

$$I_{gmin}=I_g\times(1-E_1)$$

[Equation 6]

$$I_{gmax}=I_g\times(1+E_1)$$

[Equation 7]

$$V_{gmin}=V_g\times(1-E_2)$$

[Equation 8]

$$V_{gmax}=V_g\times(1+E_2)$$

Finally, current ranges [Igmin, Igmax] at the time of the fault, current ranges [Ipremin, Ipremax] before the fault, and voltage ranges [Vgmin, Vgmax] at the time of the fault which are obtained are transmitted to the combination creating means 8.

Next, the impedance range calculating means 7 calculates a minimum impedance value ZLmin and a maximum impedance value ZLmax. First, an example of which a temperature is set as the impedance variation parameter 5 is considered. Since the impedance may be considered to be linearly changed due to the temperature, when the temperature is a temperature T, the impedance is obtained using ZL=f(T). In addition, if the temperature sensor 211 has a sensor error E3, ZLmin and ZLmax are respectively obtained using (Equation 9) and (Equation 10) .

[Equation 9]

$$Z_{Lmin}=f(t\times(1-E_3))$$

[Equation 10]

$$Z_{Lmax}=f(t\times(1+E_3))$$

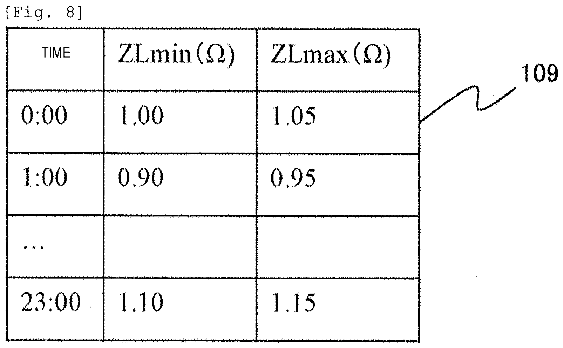

In addition, an example of which an impedance table 109 illustrated in Fig. 8 is included inside the impedance range calculating means 7 instead of a function f(t) is considered. Since a temperature of a distribution line is changed depending on a temperature of air and the temperature is changed by a time T, the minimum impedance value ZLmin and the maximum impedance value ZLmax in each time are stored in the impedance table 109. In the example, the each time means every hour; however, the time may be a time (for example, unit of 10 minutes) having a more finely divided width or a time (for example, one month) having a more greatly divided width. Finally, impedance ranges [ZLmin, ZLmax] which are obtained are transmitted to the combination creating means 8.

Next, the combination creating means 8 creates a combination {current at the time of the fault, current before the fault, a voltage at the time of the fault, and an impedance} of input parameters of the fault point locating means 9. The combination creating means 8 selects one each value from the current ranges [Igmin, Igmax] at the time of the fault, the current ranges [Ipremin, Ipremax] before the fault, the voltage ranges [Vgmin, Vgmax] at the time of the fault, and the impedance ranges [ZLmin, ZLmax], and creates a combination of the selected values. In the example, 16 values of a minimum value and a maximum value of each of the values are selected. In order to calculate a malfunction section with higher accuracy, it is possible to divide a closed section into a section of a designated number, and to create each combination of values. Finally, the entire created combination {current at the time of the fault, current before the fault, a voltage at the time of the fault, and an impedance} is transmitted to the fault point locating means 9.

Next, the fault point locating means 9 calculates a distance m from the busbar 203 to the fault point according to an algorithm of the fault point. As illustrated in NTL 1, many fault point algorithms are proposed; however, any method can also be applied to the embodiment. The invention adopts a scheme disclosed in NTL 1. In this case, if {current Ig at the time of the fault, current Ipre before the fault, a voltage Vg at the time of the fault, and an impedance ZL} is substituted to (Equation 1), the distances m are obtained. The entire combination obtained by the combination creating means 8 is applied to Equation 1, and all of the obtained distances m are transmitted to the determining means 10.

Finally, the determining means 10 calculates a maximum value and a minimum value among the obtained m described above. In the example, since 16 m are obtained, a maximum value and a minimum value of m are obtained using a bubble sort. These values are output as the fault point range 11. In addition, impedances, currents at the time of the fault, currents before the fault, and voltages at the time of the fault with the maximum value and the minimum value of m may be output. If m of the fault point range 11 is satisfied with m<0 or m>1, a malfunction point is not present on a distribution system, and thus it becomes an abnormal value. At this time, one or more of the impedance, the current at the time of the fault, the current before the fault', and the voltage at the time of the fault are possible to be errors. Therefore, in order to notify this malfunction, a determination not possible flag 12 is output. In addition, the impedance, the current at the time of the fault, the current before the fault, and the voltage at the time of the fault may be output because of debug.

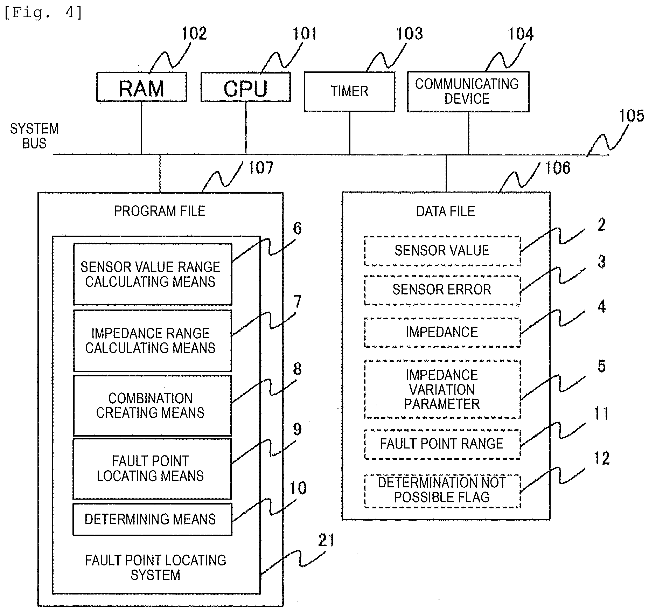

Fig. 4 is an example of a hardware configuration of the fault point locating device 1 in the example. In Fig. 4, a computer, in which a CPU 101, a RAM 102, the timer 103, a communicating device 104, a program file 107, and a data file 106 are connected by a system bus 105, constitutes the fault point locating system 21. The CPU 101 of the computer executes the fault point locating system 21 of the program file 107. The RAM 102 is a memory temporally storing result data during calculation of the fault point locating system 21.

The program file 107 and the data file 106 are constituted by a non-volatile memory such as flash memory or a magnetic disk. In the program file 107, the fault point locating system 21 which is executed by the CPU 101 is stored. The fault point locating system 21 is constituted by the sensor value range calculating means 6, the impedance range calculating means 7, the combination creating means 8, the fault point locating means 9, and the determining means 10. In the data file 106, the sensor value 2, the sensor error 3, the impedance 4, and the impedance variation parameter 5 which are input by the fault point locating system 21 are stored. In addition, the fault point range 11 and the determination not possible flag 12 which are output by the fault point locating system 21 are stored. The communicating device 104 may be a wired network such as Ethernet (registered trademark), CAN, or LIN, or may be a wireless communication such as IEEE 802. 11a or Zigbee (registered trademark). One of them is selected depending on maintenance statuses or costs of a public communication network.

Example 2

In this example, an example when the fault point locating system 21 of Example 1 is mounted on the electric power system monitoring system 13 is described. As illustrated in Fig. 7, the electric power system monitoring system 13 is a system for displaying a voltage and current on the monitor 108 in real time using online information such as the voltage sensor 209 or the electric current sensor 210 of the electric power system, and rating a fault point.

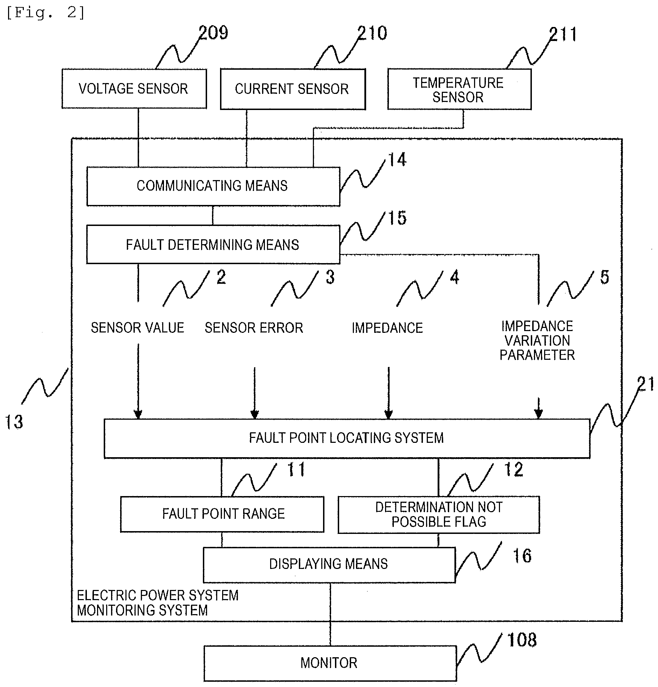

Fig. 2 is an example of a diagram of the software configuration of the electric power system monitoring system 13 in the example. In Fig. 2, the voltage sensor 209, the electric current sensor 210, and the temperature sensor 211 are input devices of the electric power system monitoring system 13. As the impedance variation parameter 5, in a case in which a temperature is not used as the parameter, the temperature sensor 211 can be omitted. The monitor 108 is an output device. Communicating means 14, fault determining means 15, the fault point locating system 21, and displaying means 16 are processes of the invention. The fault point locating system 21 performs the same processes as those of Example 1. First, the input device will be described as follows.

The voltage sensor 209 measures the voltage Vg at the time of the fault. The electric current sensor 210 measures the current Ig at the time of the fault, and the current Ipre before the fault. In addition, the temperature sensor 211 measures any one of temperatures of the busbar 203, transmission and distribution lines, and peripherals thereof. These values are finely stored at a cycle of eight times or more of a system frequency by the controller 212, and are transmitted to the electric power system monitoring system 13 through communication.

Next, processes of the example will be described in order of processing.

The communicating means 14 collects pieces of information relating to the voltage Vg at the time of the fault, the current Ig at the time of the fault, the current Ipre before the fault, and the temperatures T by communicating with the controller 212. The controller 212 determines that there is a fault in the voltage sensor 209, the electric current sensor 210, the temperature sensor 211 when the current is deviated from a designated range by polling the electric current sensor 210 at the cycle of eight times or more of the system frequency, and updates Ig and Vg. If the fault is removed, Ig and Vg are cleared to be zero. The communicating means 14 always performs polling at a predetermined cycle using the timer 103.

Next, the fault determining means 15 determines whether or not new fault is generated. In the controller 212, as illustrated in Example 1, since generation of the fault is detected in order to store the current Ig at the time of the fault and the current Ipre before the fault, this result may be used. That is, if the current Ig at the time of the fault and the voltage Vg at the time of the fault are not cleared to be zero, it is possible to determine that the fault is generated. When the fault is generated, Vg, Ig, and Ipre are written as the sensor value 2. In addition, the temperature T or the current timer 103 are written as the impedance variation parameter 5. After that, the fault point locating system 21 is driven.

Next, the fault point locating system 21 outputs the fault point range 11 and the determination not possible flag 12 in the same manner as that of the processes of Example 1.

Finally, the displaying means 16 displays the fault point range 11 and the determination not possible flag 12 on the monitor 108. The fault point range 11 may represent a range of percentages of m, and may be shown in a system diagram illustrated in Fig. 7, or on a map.

Fig. 5 is an example of a diagram of a hardware configuration of the electric power system monitoring system 13 in the example. Fig. 5 is almost the same as that of Fig. 4 of Example 1, but is different from Fig. 4 in that the monitor 108 is connected to the system bus 105 and the communicating means 14, the fault determining means 15, and the displaying means 16 are stored in the program file 107. The communicating means 14 is capable of communicating with the controller 212 which is connected to a network through the communicating device 104. In addition, the displaying means 16 is capable of displaying characters and images on the monitor 108.

Example 3

In this example, an example when the fault point locating system of Example 1 is mounted in the facility planning support system 17 is illustrated.

The facility planning support system 17 is a system for obtaining accuracy of locating a fault point at the time of generating power flow or fault of future by a simulation, and for supporting facility investment plan, using offline information such as a log of the voltage sensor 209 or the electric current sensor 210.

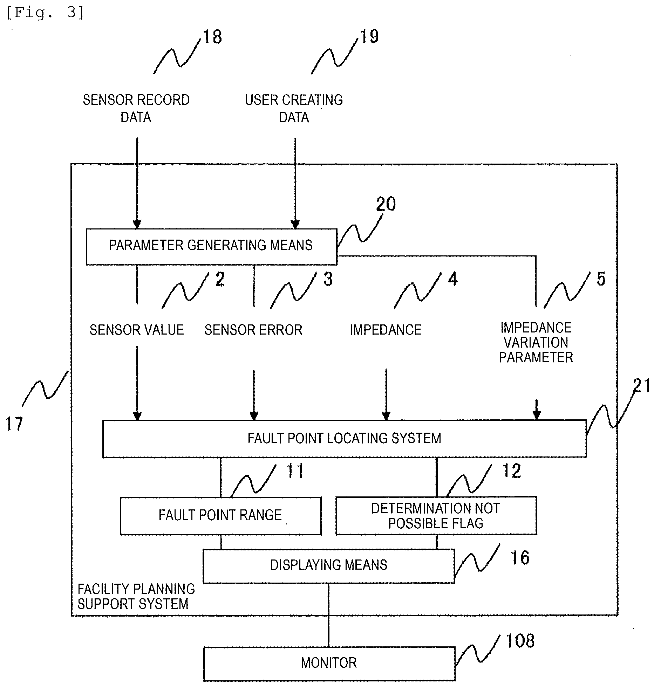

Fig. 3 is an example of a diagram of a software configuration of a facility planning system in the example. In Fig. 3, a sensor record data 18 and a user creating data 19 are input of the facility planning support system 17. The monitor 108 is an output device. Parameter generating means 20, the fault point locating system 21, and the displaying means 16 are processes of the invention. The fault point locating system 21 performs the same processes as those of Example 1. First, the input device will be described as follows.

The sensor record data 18 is a log of the voltage sensor 209, the electric current sensor 210, and the temperature sensor 211. A log at the time of generating the fault is used in order to evaluate accuracy of locating a fault point. Specifically, a voltage and current of each phase at the time of one-line ground fault, two-line ground fault, two-line short fault, three-line ground fault, and three-line short fault, are provided in chronological order. A divided width of the time is equal to or more than eight times of the system frequency. The user creating data 19 is also a chronological data of a voltage, a current, a temperature of each phase at the time of the fault, as with the sensor record data 18. The user creating data 19 is data created by a user, in order to evaluate accuracy of locating the fault point relating to voltage variation or current variation which is not logged.

Next, processes of the example will be described in order of processing.

The parameter generating means 20 determines whether or not current deviates from a designated range by scanning the sensor record data 18. If there is a deviated current, it is determined that the fault is generated, and the data is extracted as the voltage Vg at the time of the fault, the current Ig at the time of the fault, and the temperature T. In addition, the current immediately before the data is extracted as the current Ipre before the fault. Also, Vg, Ig, and Ipre are written as the sensor value 2. In addition, the temperature T or the time is written as the impedance variation parameter 5. After that, the fault point locating system 21 is driven.

Processes of the fault point locating system 21, and the displaying means 16 are the same as those of Example 2.

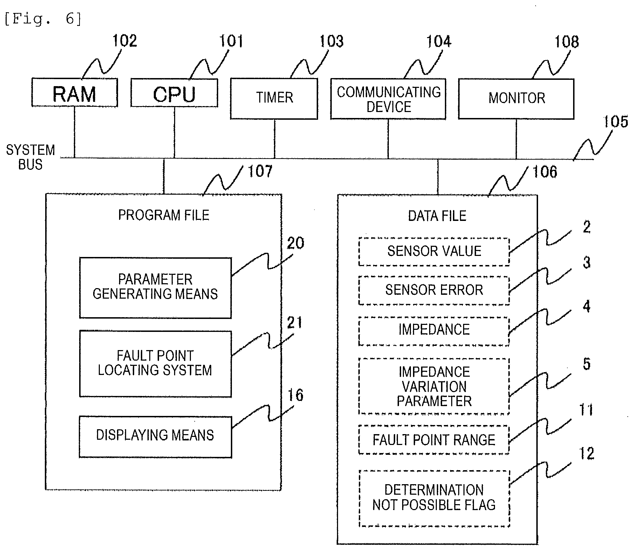

Fig. 6 is an example of a diagram of a hardware configuration of the facility planning support system 17 in the example. Fig. 6 is almost the same as that of Fig. 4 of Example 1, but is different from Fig. 4 in that the monitor 108 is connected to the system bus 105, and sensor value generating means and the displaying means 16 are stored in the program file 107. The displaying means 16 is capable of displaying characters and images on the monitor 108.

Reference Signs List

| 1 | fault point locating device |
| 2 | sensor value |
| 3 | sensor error |
| 4 | impedance |
| 5 | impedance variation parameter |
| 6 | sensor value range calculating means |
| 7 | impedance range calculating means |
| 8 | combination creating means |
| 9 | fault point locating means |
| 10 | determining means |
| 11 | fault point range |
| 12 | determination not possible flag |
| 13 | electric power system monitoring system |
| 14 | communicating means |
| 15 | fault determining means |
| 16 | displaying means |
| 17 | facility planning support system |
| 18 | sensor record data |
| 19 | user creating data |
| 20 | parameter generating means |
| 21 | fault point locating system |
| 101 | CPU |
| 102 | RAM |
| 103 | timer |
| 104 | communicating device |
| 105 | system bus |
| 106 | data file |
| 107 | program file |
| 108 | monitor |
| 109 | impedance table |
| 201 | distribution substation |
| 202 | behind impedance |
| 203 | busbar |
| 204 | impedance from busbar to fault point |
| 205 | fault point |
| 206 | impedance from fault point to load |
| 207 | load |
| 208 | resistance of fault point |

| 209 | voltage sensor |
| --- | --- |
| 210 | electric current sensor |
| 211 | temperature sensor |
| 212 | controller |
| 213 | communication network |

**Claims**

1.  A fault point locating device which estimates a fault point in an electric power system, the device comprising:

    variation range calculating means for obtaining a range of variation of sensor values and an impedance, based on a sensor value including a measured voltage value and a measured current value before and after fault, which are measured using sensors installed in the electric power system, a sensor error representing an error range of the sensor in relation to measurement of the sensor value, an impedance of the electric power system, and an impedance variation parameter for determining the range of variation of the impedance;
    combination creating means for creating a combination of values that the sensor value and the impedance are able to attain, based on the range of variation obtained by the variation range calculating means; and
    fault point locating means for calculating a fault point range representing a distance from the sensor to the fault point based on the combination.

2.  The fault point locating device according to Claim 1, further comprising:

    determining means for calculating a difference between a maximum distance of the fault point and a minimum distance of the fault point obtained by the fault point locating means and storing the difference as information of the fault point range.

3.  The fault point locating device according to Claim 2, wherein the determining means outputs a determination not possible flag when the fault point range is outside of a range of a feeder.

4.  An electric power system monitoring system which communicates with the fault point locating device according to Claim 1, the system comprising:

    a displaying unit that receives a sensor value at the time of the fault from a sensor, transmits the sensor value to the fault point locating device, receives a fault point range from the fault point locating device, and displays the range on an operation screen.

5.  A facility planning support system which communicates with the fault point locating device according to Claim 1, the system comprising:

    a displaying unit that includes a database in which information relating to variation of current or voltage, an accuracy of a sensor, and an impedance in an electric power system are stored, receives the information at the time of the fault from the database, transmits the information to the fault point locating device, receives a fault point range from the fault point locating device, and displays the range on an operation screen.

6.  A fault point locating method which estimates a fault point in an electric power system, the method comprising:

    a step of obtaining a range of variation of sensor values and an impedance, based on a sensor value including a measured voltage value and a measured current value before and after fault, which are measured using sensors installed in the electric power system, a sensor error representing an error range of the sensor in relation to measurement of the sensor value, an impedance of the electric power system, and an impedance variation parameter for determining the range of variation of the impedance;
    a step of creating a combination of values that the sensor value and the impedance are able to attain, based on the range of variation obtained by the variation range calculating means; and
    a step of calculating a fault point range representing a distance from the sensor to the fault point based on the combination.

[Fig. 1]

[Fig. 2]

```
         209              210                211
VOLTAGE SENSOR    CURRENT SENSOR    TEMPERATURE
                                      SENSOR
```

COMMUNICATING MEANS  14

FAULT DETERMINING MEANS  15

SENSOR VALUE  2    SENSOR ERROR  3    IMPEDANCE  4    IMPEDANCE VARIATION PARAMETER  5

13

FAULT POINT LOCATING SYSTEM  21

FAULT POINT RANGE  11    DETERMINATION NOT POSSIBLE FLAG  12

DISPLAYING MEANS  16

ELECTRIC POWER SYSTEM MONITORING SYSTEM

MONITOR  108

[Fig. 3]

```
        ∿18                    ∿19
  SENSOR RECORD          USER CREATING
       DATA                   DATA
         │                     │
         ▼                     ▼
    ┌──────────────────────────────────┐      ∿20
    │     PARAMETER GENERATING MEANS    │
    └──────────────────────────────────┘
         │      ∿2      │    ∿3         ∿4            ∿5
         │              │
    SENSOR VALUE   SENSOR ERROR    IMPEDANCE      IMPEDANCE
                                                  VARIATION
                                                  PARAMETER
                                                                        ∿21
 ∿
 17      ▼              ▼              ▼            ▼
    ┌──────────────────────────────────────────────────┐
    │            FAULT POINT LOCATING SYSTEM            │
    └──────────────────────────────────────────────────┘
         │       ∿11                  │     ∿12
    ┌──────────────────┐        ┌──────────────────────┐
    │ FAULT POINT RANGE│        │  DETERMINATION NOT   │
    └──────────────────┘        │     POSSIBLE FLAG    │
         │                      └──────────────────────┘
    ┌──────────────────────────────────┐    ∿16
    │          DISPLAYING MEANS         │
    └──────────────────────────────────┘
  FACILITY PLANNING
  SUPPORT SYSTEM
                     │
              ┌──────────────────────┐    ∿108
              │       MONITOR         │
              └──────────────────────┘
```

[Fig. 4]

[Fig. 5]

[Fig. 6]

[Fig. 7]

[Fig. 8]

| TIME | ZLmin ($\Omega$) | ZLmax ($\Omega$) |
|------|-------|-------|
| 0:00 | 1.00 | 1.05 |
| 1:00 | 0.90 | 0.95 |
| ... | | |
| 23:00 | 1.10 | 1.15 |

109

## INTERNATIONAL SEARCH REPORT

| International application No. |
|---|
| PCT/JP2016/052847 |

**A.  CLASSIFICATION OF SUBJECT MATTER**
*G01R31/08*(2006.01)i, *H02H3/00*(2006.01)i

According to International Patent Classification (IPC) or to both national classification and IPC

**B.  FIELDS SEARCHED**

Minimum documentation searched (classification system followed by classification symbols)
G01R31/08, H02H3/00

Documentation searched other than minimum documentation to the extent that such documents are included in the fields searched
Jitsuyo Shinan Koho        1922-1996   Jitsuyo Shinan Toroku Koho   1996-2016
Kokai Jitsuyo Shinan Koho   1971-2016   Toroku Jitsuyo Shinan Koho   1994-2016

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| A | C37.114-2004 - IEEE Guide for Determining Fault Location on AC Transmission and Distribution Lines, IEEE, 2005.06.08, p. 8-9 | 1-6 |
| A | JP 06-074996 A  (Toshiba Corp.), 18 March 1994 (18.03.1994), paragraphs [0019] to [0021] & EP 578123 A2 page 10, line 30 to page 12, line 3 | 1-6 |
| A | JP 04-134274 A  (Fuji Electric Co., Ltd.), 08 May 1992 (08.05.1992), page 5, lower right column, line 16 to page 6, upper left column, line 20 (Family: none) | 1-6 |

| ☒   Further documents are listed in the continuation of Box C. | ☐   See patent family annex. |
|---|---|

| *     Special categories of cited documents: | "T"   later document published after the international filing date or priority date and not in conflict with the application but cited to understand the principle or theory underlying the invention |
|---|---|
| "A"   document defining the general state of the art which is not considered   to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| 30 March 2016 (30.03.16) | 12 April 2016 (12.04.16) |

| Name and mailing address of the ISA/ | Authorized officer |
|---|---|
| Japan Patent Office 3-4-3,Kasumigaseki,Chiyoda-ku, Tokyo 100-8915,Japan | |
| | Telephone No. |

Form PCT/ISA/210 (second sheet) (January 2015)

## INTERNATIONAL SEARCH REPORT

| International application No. |
|---|
| PCT/JP2016/052847 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 09-026453 A  (Kabushiki Kaisha FMT), 28 January 1997 (28.01.1997), paragraphs [0022] to [0023] (Family: none) | 1-6 |
| A | JP 08-015006 A  (Matsushita Electric Industrial Co., Ltd.), 19 January 1996 (19.01.1996), paragraphs [0035] to [0043] (Family: none) | 1-6 |

Form PCT/ISA/210 (continuation of second sheet) (January 2015)

**EP 3 264 114 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4313169 A